(19) **Europäisches Patentamt / European Patent Office / Office européen des brevets**

(11) **EP 4 542 643 B1**

(12) **EUROPEAN PATENT SPECIFICATION**

(45) Date of publication and mention
of the grant of the patent:
**05.11.2025 Bulletin 2025/45**

(21) Application number: **24194976.7**

(22) Date of filing: **16.08.2024**

(51) International Patent Classification (IPC):
***H01L 23/427*** (2006.01)     ***H01L 23/367*** (2006.01)

(52) Cooperative Patent Classification (CPC):
**H01L 23/3675; H01L 23/427**

(54) **SEMICONDUCTOR DEVICE HAVING HOLLOW CAPILLARY STRUCTURE**

HALBLEITERANORDNUNG MIT EINER HOHLEN KAPILLARSTRUKTUR

DISPOSITIF SEMI-CONDUCTEUR AYANT UNE STRUCTURE CAPILLAIRE CREUSE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **17.10.2023 KR 20230138997**

(43) Date of publication of application:
**23.04.2025 Bulletin 2025/17**

(73) Proprietor: **Samsung Electronics Co., Ltd.
Gyeonggi-do, 16677 (KR)**

(72) Inventors:
• **KANG, Sungchan
16678 Suwon-si (KR)**
• **KIM, Dongkyun
16678 Suwon-si (KR)**
• **SON, Daehyuk
16678 Suwon-si (KR)**
• **LEE, Hotaik
16678 Suwon-si (KR)**
• **HONG, Seogwoo
16678 Suwon-si (KR)**

(74) Representative: **Elkington and Fife LLP
Prospect House
8 Pembroke Road
Sevenoaks, Kent TN13 1XR (GB)**

(56) References cited:
**US-A1- 2012 033 385     US-A1- 2019 348 345
US-A1- 2021 310 745**

Processed by Luminess, 75001 PARIS (FR)

## Description

FIELD OF THE INVENTION

The disclosure relates to a semiconductor device having a hollow capillary structure.

BACKGROUND OF THE INVENTION

Air cooling devices may be used to remove heat generated in electronic devices. According to the gradual increase in the power density of electronic devices, liquid cooling devices have been more used to deal with the increased heat generation amount. In the case of data centers, there has been a growing interest in highly efficient next-generation cooling methods such as methods using liquid cooling devices to reduce power consumption. Liquid cooling methods may be divided according to a temperature range of a heat-generating portion into single-phase liquid cooling methods without a phase change of coolant and two-phase liquid cooling methods which involve a phase change of coolant. The two-phase cooling method has a wider range of heat generation amount that can be handled than the single-phase cooling method.

US 2019/348345 A1 discloses a vapor chamber lid device which includes: an evaporator plate; a condenser plate attached to the evaporator plate such that a cavity is formed between the evaporator plate and the condenser plate; a thermal insulation layer sandwiched between the evaporator plate and the condenser plate; and a working fluid enclosed within the cavity, wherein the working fluid partially fills the cavity.

SUMMARY OF THE INVENTION

Provided is a semiconductor device having a cooling structure capable of supplying a large amount of coolant by using a capillary structure.

According to an aspect of the disclosure, a semiconductor device includes: a semiconductor chip including a semiconductor integrated circuit; a heat transfer member covering an upper surface of the semiconductor chip; and a plurality of microstructures on an upper surface of the heat transfer member and configured to generate a capillary force to cause a flow of a coolant, wherein a first capillary channel is provided between adjacent microstructures of the plurality of microstructures, and at least one of the plurality of microstructures may include a hollow microstructure in which a second capillary channel is provided.

A difference between a first capillary interval of the first capillary channel and a second capillary interval of the second capillary channel may be less than or equal to half of any of the first capillary interval and the second capillary interval.

A first capillary interval of the first capillary channel may be the same as a second capillary interval of the second capillary channel.

The first capillary channel may be interconnected with the second capillary channel.

A first opening interconnecting the first capillary channel with the second capillary channel may be provided at at least one of ends of the hollow microstructure in an extension direction of the second capillary channel.

A second opening, open in a direction perpendicular to an extension direction of the second capillary channel, may be provided at the hollow microstructure.

An opening interval of the second opening may be less than or equal to half of a second capillary interval of the second capillary channel.

According to an aspect of the disclosure, a semiconductor device includes: a semiconductor chip including a semiconductor integrated circuit; a cooling channel thermally connected to the semiconductor chip and configured to accommodate a coolant which flows therein; and a plurality of microstructures in the cooling channel and configured to generate a capillary force to cause a flow of the coolant, wherein a first capillary channel is provided between adjacent microstructures of the plurality of microstructures, and at least one of the plurality of microstructures may include a hollow microstructure in which a second capillary channel is provided.

A difference between a first capillary interval of the first capillary channel and a second capillary interval of the second capillary channel may be less than or equal to half of any of the first capillary interval and the second capillary interval.

A first capillary interval of the first capillary channel may be the same as a second capillary interval of the second capillary channel.

The first capillary channel may be interconnected with the second capillary channel.

A first opening interconnecting the first capillary channel with the second capillary channel may be provided at at least one of ends of the hollow microstructure in an extension direction of the second capillary channel.

A second opening, open in a direction perpendicular to an extension direction of the second capillary channel, may be provided at the hollow microstructure.

An opening interval of the second opening may be less than or equal to half of a second capillary interval of the second capillary channel.

The semiconductor chip may include a lower surface and an upper surface opposite to the lower surface, the semiconductor integrated circuit may be on the lower surface, and the cooling channel may be adjacent to the upper surface.

The plurality of microstructures are on the upper surface of the semiconductor chip.

The semiconductor device may further include a housing surrounding the semiconductor chip, the cooling channel may be between the housing and the upper surface of the semiconductor chip.

At least one opening interconnected with the cooling channel may be provided in the housing.

The semiconductor chip may include a lower surface and an upper surface opposite to the lower surface, the semiconductor integrated circuit may be on the lower surface, and the cooling channel may be recessed from the upper surface.

The plurality of microstructures may be on a bottom surface of the cooling channel that is closer to the lower surface of the semiconductor chip than to the upper surface of the semiconductor chip.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic block diagram of a semiconductor device according to one or more embodiments;

FIG. 2 is a detailed view of a plurality of microstructures of FIG. 1 according to one or more embodiments;

FIG. 3 is a schematic perspective view of the plurality of microstructures illustrated in FIG. 1 according to one or more embodiments;

FIG. 4A, FIG. 4B, FIG. 4C, and FIG. 4D are diagrams illustrating various arrangement examples of the plurality of microstructures according to one or more embodiments;

FIG. 5A, FIG. 5B, FIG. 5C, and FIG. 5D are diagrams each illustrating an example of a method of manufacturing a microstructure according to one or more embodiments illustrated in FIG. 1, FIG. 2, and FIG. 3 ;

FIG. 6A and FIG. 6B are schematic perspective views of examples of a microstructure according to one or more embodiments;

FIG. 7 is a schematic block diagram of an example of a semiconductor device according to one or more embodiments;

FIG. 8 is a schematic block diagram of an example of a semiconductor device according to one or more embodiments;

FIG. 9 is a schematic block diagram of an example of a semiconductor device; and

FIG. 10 is a schematic block diagram of an example of a semiconductor device according to one or more embodiments.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, example embodiments will be described in detail with reference to the accompanying drawings. In the drawings, like reference numerals in the drawings denote like elements, and sizes of components in the drawings may be exaggerated for clarity and convenience of explanation. Meanwhile, embodiments described below are provided only as an example, and thus can be embodied in various forms. It will be understood that when a component is referred to as being "on" or "over" another component, the component can be directly on, under, on the left of, or on the right of the other component, or can be on, under, on the left of, or on the right of the other component in a non-contact manner. An expression used in the singular encompasses the expression of the plural, unless it has a clearly different meaning in the context. When a portion "includes" an element, another element may be further included, rather than excluding the existence of the other element, unless otherwise described. The use of the terms "a" and "an" and "the" and similar referents in the context of describing embodiments (especially in the context of the following claims) are to be construed to cover both the singular and the plural. The operations of all methods described herein can be performed in any suitable order unless otherwise indicated herein or otherwise clearly contradicted by context, and embodiments are not limited to the described order of the operations. Moreover, the terms "part," "module," etc. refer to a unit processing at least one function or operation, and may be implemented by a hardware, a software, or a combination thereof. The connecting lines, or connectors shown in the various figures presented are intended to represent exemplary functional relationships and/or physical or logical couplings between the various elements, and thus it should be noted that many alternative or additional functional relationships, physical connections or logical connections may be present in a practical device. The use of any and all examples, or exemplary language provided herein, is intended merely to better illuminate technical ideas and does not pose a limitation on the scope of embodiments unless otherwise claimed.

Efficient cooling systems have been required to overcome the cooling issues which have been a factor limiting the performance of electronic devices including semiconductor chips. In the case of semiconductor devices to which high performance computing (HPC) and stacked three-dimensional (3D) semiconductor chips are applied, there has been a demand for cooling systems capable of respond to the increased power density and heat generation amount due to the high integration degree. To meet such demand, a two-phase cooling system using the evaporative latent heat of coolant may be applied to semiconductor devices. The two-phase cooling method may include immersion cooling, spray cooling, jet impingement cooling, etc. Coolants used in the immersion cooling may be limited to dielectric coolants. The spray cooling may require a pumping device capable of operating at high pressure, and spray nozzles need constant maintenance. In the jet impingement cooling, multiple injectors are essential for evenly cooling a heating surface, and there still be a possibility of blind spot that the coolant jet fails to reach even when multiple injectors are used.

A semiconductor device according to one or more embodiments of the disclosure employs a two-phase liquid cooling system which involves a phase change of a coolant. In a two-phase cooling system, to prevent dryout, a sufficient amount of coolant needs to be supplied evenly to a heat exchange surface. In addition, to prevent a hot spot causing a local overheat of the heat exchange surface, it is necessary to quickly remove bubbles (vapor coolant) from the heat exchange surface, and a liquid coolant needs to be rapidly supplied in an area from which the vapor coolant is removed. According to the disclosure, to cool a semiconductor chip, a plurality of microstructures causing a flow of a coolant by using a capillary force may be employed. The plurality of microstructures may be referred to as a capillary structure or a wick. The plurality of microstructures may be provided on a heat exchange surface on which heat exchange with the semiconductor chip directly or indirectly occurs. The plurality of microstructures may be arranged to form a capillary channel (first capillary channel) between microstructures adjacent to each other. At least some of the plurality of microstructures may have a hollow shape in which a capillary channel (second capillary channel) is formed. According to such structure, as the first capillary channel and the second capillary channel form a coolant flow path in which a coolant moves, a relatively large amount of coolant may be rapidly supplied to a heat exchange surface. In addition, by employing a hollow microstructure, a surface area of the heat exchange surface may increase.

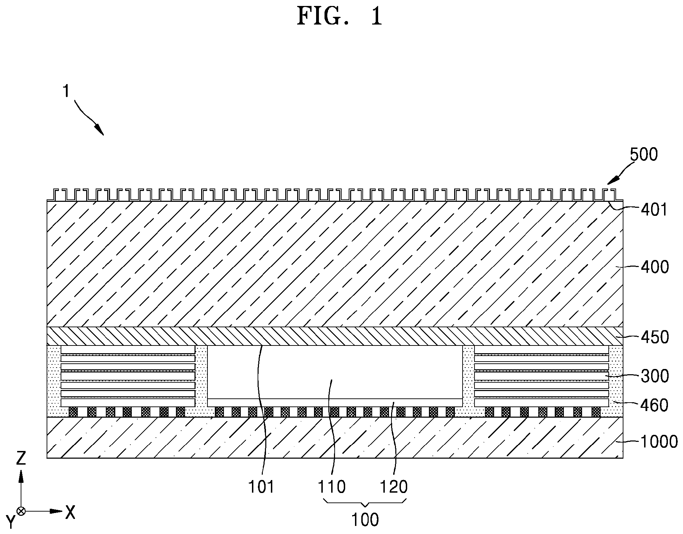

Hereinafter, embodiments of a semiconductor device to which a plurality of microstructures including a hollow microstructure is applied are described. In the embodiments below, a first direction (an X direction) refers to a direction from among directions parallel with an upper surface of a semiconductor device. A second direction (a Y direction) refers to a direction perpendicular to the first direction (the X direction) from among the directions parallel with the upper surface of the semiconductor device. A third direction (a Z direction) refers to a thickness direction of the semiconductor device. FIG. 1 is a schematic block diagram of a semiconductor device 1 according to an embodiment. Referring to FIG. 1, the semiconductor device 1 according to an embodiment may include a semiconductor chip 100, a heat transfer member 400, and a plurality of microstructures 500.

The semiconductor chip 100 may include a substrate 110 and a semiconductor integrated circuit 120 formed on a surface of the substrate 110. An upper surface 101 of the semiconductor chip 100 may be an upper surface of the substrate 110, and the semiconductor integrated circuit 120 may be formed on a lower surface of the substrate 110. The semiconductor chip 100 may be various semiconductor integrated circuit chips. For example, the semiconductor chip 100 may be a memory chip including a memory integrated circuit, a logic chip including a logic integrated circuit, e.g., a central processing unit (CPU) chip, a graphic processing unit (GPU) chip, an application specific integrated circuit (ASIC) chip, etc. To implement the semiconductor device 1 having a small form factor, the semiconductor chip 100 may be a semiconductor integrated circuit chip of wafer level. The substrate 110 may be a wafer.

The semiconductor device 1 may include another semiconductor chip 300 arranged in a two-dimensional (2D) manner with respect to the semiconductor chip 100. In the embodiment, the semiconductor chip 300 may be arranged on both sides of the semiconductor chip 100 in the first direction (X direction). The semiconductor chip 300 may also be arranged on both sides of the semiconductor chip 100 in the second direction (Y direction). For example, the semiconductor chip 100 may be a logic chip, and the semiconductor chip 300 may be a memory chip. For example, the semiconductor chip 300 may be a high bandwidth memory (HBM). The semiconductor chip 300 may include a plurality of HBMs stacked in the third direction (Z direction).

A wiring layer for electrically connecting the semiconductor integrated circuit 120 to a printed circuit board 1000 may be provided on the lower surface of the semiconductor chip 100. The wiring layer may be electrically passivated against the outside. The semiconductor chip 100 and the semiconductor chip 300 may be mounted on the printed circuit board 1000 directly or indirectly with an interposer arranged therebetween. The semiconductor chip 100 may be referred to as an integrated circuit die, and a device 1 including the integrated circuit die may be referred to as an integrated circuit device.

The heat transfer member 400 may cover the upper surface 101 of the semiconductor chip 100. The heat transfer member 400 may be thermally connected to the semiconductor chip 100, and heat generated at the semiconductor chip 100 may be transferred to the heat transfer member 400. The heat transfer member 400 may include a material having high thermal conductivity, for example, a metal such as copper (Cu), etc. A thermal interface material (TIM) 450 may be arranged between the heat transfer member 400 and the upper surface 101 of the semiconductor chip 100. The TIM 450 may lower thermal boundary resistance between the heat transfer member 400 and the upper surface 101 of the semiconductor chip 100 and relieve thermal stress due to a difference in thermal expansion coefficient between the heat transfer member 400 and the semiconductor chip 100. Accordingly, an improved thermal coupling may be formed between the semiconductor chip 100 and the heat transfer member 400, and the heat may be efficiently transferred from the semiconductor chip 100 to a coolant described below. The TIM 450 may be implemented in various forms including a paste, an adhesive, a pad, a filler, etc. The reference numeral 460 denotes a sealing member. The sealing member 460 may protect an active surface of the printed circuit board 1000, the semiconductor chip 100, and the semiconductor chip 300 from a coolant. In an embodiment, the sealing member 460 may include epoxy, etc. In an embodiment, the sealing member 460 may include a TIM. Accordingly, the heat from the printed circuit board 1000 may be effectively transferred to the heat transfer member 400. In the embodiment, the heat transfer member 400 may entirely cover the upper surfaces of the semiconductor chip 100 and the semiconductor chip 300 with the TIM 450 arranged between the heat transfer member 400 and the upper surfaces.

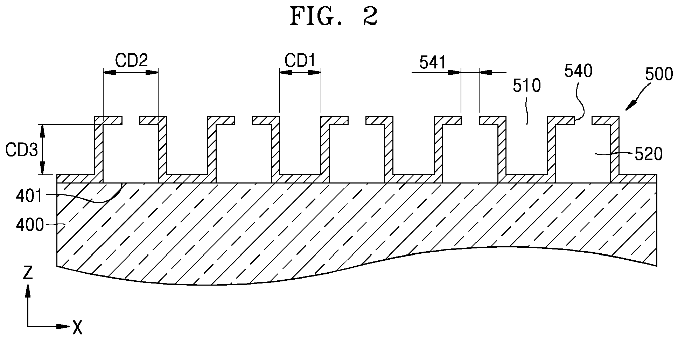

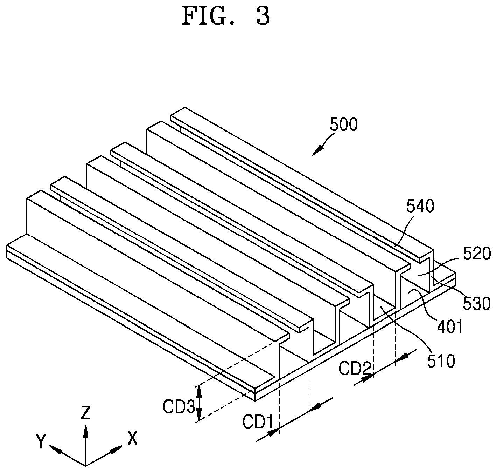

FIG. 2 is a detailed view of the plurality of microstructures 500 of FIG. 1 according to one or more embodiments. FIG. 3 is a schematic perspective view of the plurality of microstructures 500 illustrated in FIG. 1 according to one or more embodiments. Referring to FIG. 1, 2, and 3, the plurality of microstructures 500 are provided on an upper surface 401 of the heat transfer member 400. The plurality of microstructures 500 may protrude from the upper surface 401 of the heat transfer member 400. The plurality of microstructures 500 generate a capillary force causing a flow of the coolant (liquid coolant). The plurality of microstructures 500 include therein channels generating the capillary force which moves a liquid coolant that exchanges heat with the heat transfer member 400. The channels include, a first capillary channel 510 and a second capillary channel 520. The plurality of microstructures 500 form the first capillary channel 510 between two adjacent microstructures 500 arranged apart from each other. The first capillary channel 510 may be an outer capillary channel formed outside of the plurality of microstructures 500. The first capillary channel 510 may be a channel of which upper portion in a thickness direction of the semiconductor chip 100, i.e., the third direction (Z direction) is open. The second capillary channel 520 is formed in at least some of the plurality of microstructures 500. In other words, the plurality of microstructures 500 include a hollow microstructure in which the second capillary channel 520 is formed. In the embodiment, all of the plurality of microstructures 500 may be formed as a hollow microstructure. Hereinafter, a microstructure refers to a hollow microstructure, unless otherwise described. The second capillary channel 520 is an inner capillary channel formed inside the hollow microstructure. The second capillary channel 520 may be a channel which is open towards the heat exchange surface, for example, the upper surface 401 of the heat transfer member 400.

An outer interval CD1, an inner interval CD2, and a height CD3 of the plurality of microstructures 500 may be determined to generate the capillary force causing a flow of the coolant to the first capillary channel 510 and the second capillary channel 520. As the heights CD3 of the first capillary channel 510 and the second capillary channel 520 are identical to each other, the outer interval CD1 may be referred to as a first capillary interval (or a width) of the first capillary channel 510, and the inner interval CD2 may be referred to as a second capillary interval (or a width) of the second capillary channel 520. In the embodiment, the plurality of microstructures 500 may extend in the second direction (Y direction) and may be arranged apart from each other at the outer interval CD1 in the first direction (X direction).

For example, a capillary force in a pipe including a wick may be defined by Equation (1) below. In Equation (1), $\Delta P_c$ represents a capillary force, $\sigma$ represents a surface tension, and $r_c$ represents a capillary radius:

$$\Delta P_c = 2\frac{\sigma}{r_c} \quad \text{...Equation (1).}$$

At a capillary limit, the capillary force is identical to the pressure for moving a coolant through a wick, i.e., $\Delta P_L$ According to Darcy's law, the aforementioned pressure is obtained from Equation (2) below. In Equation (2), $\mu_L$ represents a dynamic viscosity of coolant, $L_{eff}$ represents an effective length of pipe, K represents a permeability of wick, A represents a cross-sectional area of wick, and V represents a volume flow rate:

$$\Delta P_L = \frac{\mu_L L_{eff}}{KA_w} V \quad \text{...Equation (2).}$$

The volume flow rate may be obtained from Equation (3) below. In Equation (3), Q represents a heat transfer rate, $\rho$ represents a density of coolant, and $\Delta H_{vap}$ represents an evaporative latent heat:

$$V = \frac{Q}{\Delta H_{vap}\rho} \quad \text{..Equation (3).}$$

Equation (4) may be derived from Equations (1), (2), and (3):

$$Q = 2\frac{KA_w \Delta H_{vap}\rho\sigma}{\mu_L L_{eff} r_c} \quad \text{...Equation (4).}$$

From Equation (4), for example, a proper $r_c$

value may be obtained considering a heat generation amount of the semiconductor chip 100.

A radius of equivalent circle corresponding to a flow cross-sectional area of each of the first capillary channel 510 and the second capillary channel 520 may be determined by an external interval CD1, an internal interval CD2, and the height CD3 of the plurality of microstructures 500. As the heights of flow cross-sectional areas of the first capillary channel 510 and the second capillary channel 520 are identical to each other (CD3), the external interval CD1 and the internal interval CD2 of the plurality of microstructures 500 may be properly determined considering $r_c$ calculated from Equations (1), (2), (3), and (4).

The heat generated at the semiconductor integrated circuit 120 of the semiconductor chip 100 may be transferred to the heat transfer member 400 via the substrate 110 and the TIM 450. A liquid coolant may be supplied to an area in which the plurality of microstructures 500 are formed. For example, the liquid coolant may be supplied in the form of continuous flow. For example, in the case of immersion cooling, as the semiconductor device 1 is entirely immersed into the liquid coolant, the liquid coolant may be supplied to the area in which the plurality of microstructures 500 are formed. The liquid coolant may be quickly supplied to the upper surface 401 of the heat transfer member 400, which is a heat exchange surface, along the first capillary channel 510 and the second capillary channel 520 formed by the plurality of microstructures 500. The liquid coolant may be heated through the heat exchange with the heat transfer member 400 and may be phase-changed into a vapor coolant. The vapor coolant may come out of the first capillary channel 510 and the second capillary channel 520. In the area of the first capillary channel 510 and the second capillary channel 520, from which the vapor coolant has left, the liquid coolant may be supplied and filled by the capillary force generated by the plurality of microstructures 500. In this manner, a two-phase cooling structure may be implemented.

As such, according to the plurality of microstructures 500 forming the first capillary channel 510 and the second capillary channel 520 , as the coolant supplied to the upper surface 401 of the heat transfer member 400, which is a heat exchange surface, may be almost doubled, compared to the case where the second capillary channel 520 is not formed, the cooling capacity and the cooling efficiency may be improved. In addition, as a sufficient amount of coolant is supplied to the first capillary channel 510 and the second capillary channel 520, the vapor coolant may be easily removed from the upper surface 401 of the heat transfer member 400, and generation of hot spot may be reduced or prevented. Moreover, according to the plurality of microstructures 500 forming the first capillary channel 510 and the second capillary channel 520, in comparison with the case where the second capillary channel 520 is not formed, a contact area between the liquid coolant and the upper surface 401 of the heat transfer member 400 may increase. Thus, the heat exchange between the liquid coolant and the heat transfer member 400 may be performed effectively. As an area of heat exchange surface is increased by the plurality of microstructures 500 formed on the upper surface 401 of the heat transfer member 400, which is a heat exchange surface, the semiconductor chip 100 may be cooled effectively.

When the liquid coolant flows excessively to any one of the first capillary channel 510 and the second capillary channel 520 , the other one may not receive a sufficient amount of liquid coolant. Then, the liquid coolant may not be sufficiently supplied to an area of the upper surface 401 of the heat transfer member 400, which corresponds to the other one of the first capillary channel 510 and the second capillary channel 520, resulting in insufficient cooling performance, and generation of hot spot and dryout. To evenly supply the liquid coolant to the entire upper surface 401 of the heat transfer member 400, the difference in flow rate of liquid coolant flowing along the first capillary channel 510 and the second capillary channel 520 needs to be small. The outer interval CD1 and the inner interval CD2 may respectively affect the flow rates of liquid coolant flowing along the first capillary channel 510 and the second capillary channel 520. When a difference between the first capillary interval of the first capillary channel 510, i.e., the outer interval CD1 and the second capillary interval of the second capillary channel 520, i.e., the inner interval CD2 is greater than a certain difference value, for example, 50%, the liquid coolant may mostly flow along a channel having a greater value between the first capillary channel 510 and the second capillary channel 520, and may hardly flow along the other channel having a less value. For example, when the second capillary interval is less than 1/2 of the first capillary interval, the liquid coolant may hardly flow along the second capillary channel 520, and most of the liquid coolant may flow along the first capillary channel 510. Considering the above, the difference between the first capillary interval of the first capillary channel 510, i.e., the outer interval CD1 and the second capillary interval of the second capillary channel 520, i.e., the inner interval CD2 may be less than or equal to 50%. In this manner, the liquid coolant may be evenly supplied to the entire upper surface 401 of the heat transfer member 400.

In an embodiment, the first capillary interval of the first capillary channel 510, i.e., the outer interval CD1 and the second capillary interval of the second capillary channel 520, i.e., the inner interval CD2 may be identical to each other. Then, almost the same amount of liquid coolant may flow in the first capillary channel 510 and the second capillary channel 520, and the coolant may be evenly supplied to the entire heat exchange surface. In addition, the size of bubbles generated by the phase change of the liquid coolant may rely on the size of structure forming the flow path, and by setting the outer interval CD1 and the inner interval CD2 to be identical to each other, the sizes of the bubbles generated in the first capillary channel 510 and the second capillary channel 520 may be identical to each other.

The first capillary channel 510 and the second capillary channel 520 may be interconnected to each other. For example, the first opening 530 may be provided at the microstructure 500 in which the second capillary channel 520 is formed. The first opening 530 may be provided at least at one of the both ends of the microstructure 500 in the extension direction of the second capillary channel 520, i.e., the second direction (Y direction). The extension direction is along a longitudinal, or longest, axis of the respective capillary channel as compared to the other physical, 3D axes of the respective capillary channel. The extension direction of the second capillary channel 520 may be a flow direction of liquid coolant in the second capillary channel 520. The size of the first opening 530 may be less than or equal to the inner interval CD2. In an embodiment, the size of the first opening 530 may be identical to the size of cross-section of the second capillary channel 520. In the embodiment, the first opening 530 may be provided at each of the both ends of the microstructure 500 in the second direction (Y direction). Accordingly, the second capillary channel 520 formed in the microstructure 500 may have both ends in the second direction (Y direction) which are open and may be connected to the first capillary channel 510. Thus, the coolant may move from the second capillary channel 520 to the first capillary channel 510 or vice versa. In addition, the bubbles generated in the second capillary channel 520, i.e., the vapor coolant may be discharged to the first capillary channel 510 through the first opening 530. As the first capillary channel 510 is a channel having an open upper portion, the vapor coolant may be easily discharged from the first capillary channel 510.

The first capillary channel 510 may be entirely open in a direction opposite to the upper surface 401 of the heat transfer member 400. The second capillary channel 520 may be partially open in the direction opposite to the upper surface 401 of the heat transfer member 400. The second opening 540 may be provided at the microstructure 500. The second opening 540 may be open in a direction perpendicular to the extension direction of the second capillary channel 520 of the microstructure 500, i.e., the second direction (Y direction), that is, the third direction (Z direction). When an opening interval 541 of the second opening 540 is too large, this may affect the radius of equivalent circle corresponding to the cross-section of the second capillary channel 520, and further, the flow of the coolant flowing along the second capillary channel 520. The opening interval 541 of the second opening 540 may be sized to less affect the flow of the coolant formed by the second capillary channel 520. For example, the opening interval 541 of the second opening 540 may be less than or equal to 1/2 of the second capillary interval of the second capillary channel 520, i.e., the inner interval CD2. The second opening 540 may be a discharge path of the bubbles generated in the second capillary channel 520, i.e., the vapor coolant. Moreover, the second opening 540 may be a discharge path of the sacrificial layer in the manufacturing process of the microstructures 500 described below.

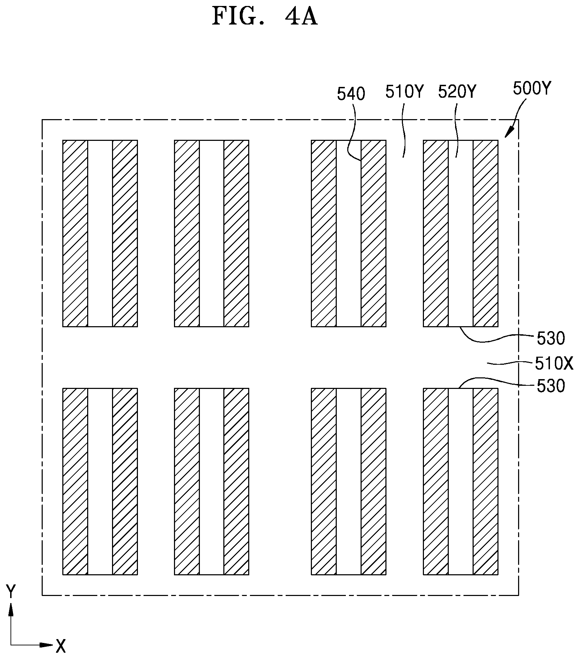

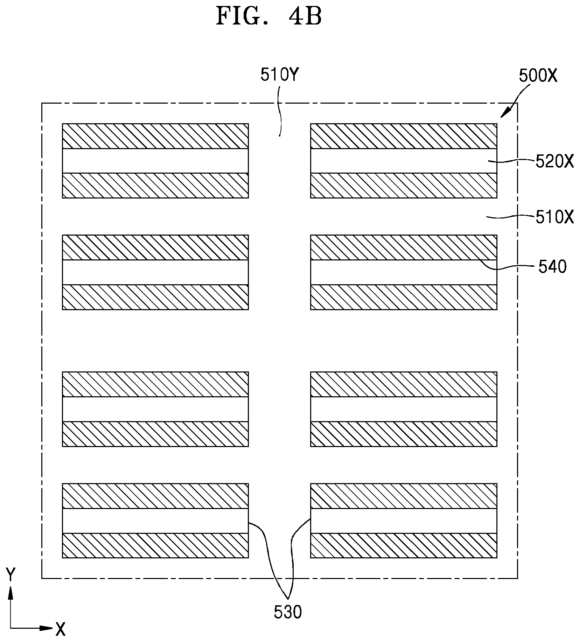

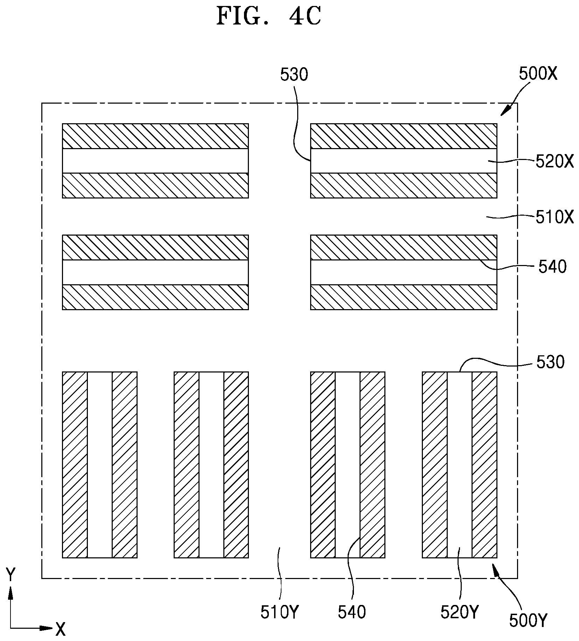

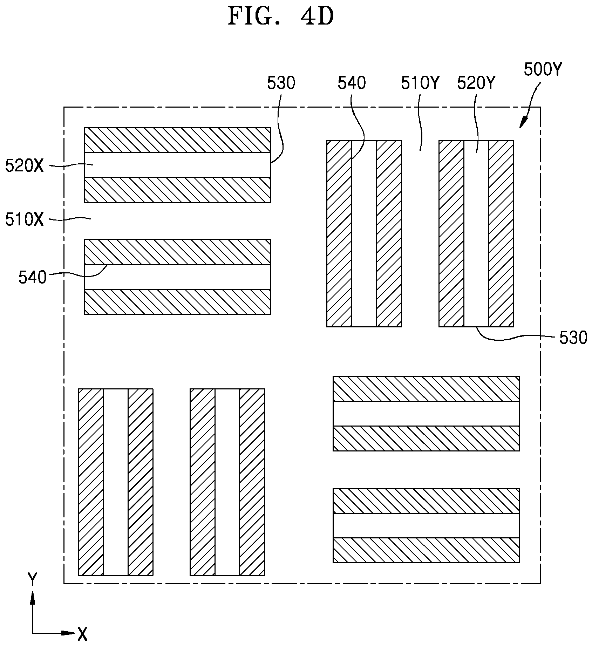

The arrangement of the plurality of microstructures 500 may vary. FIGS. 4A, 4B, 4C, and 4D are diagrams illustrating various arrangement examples of the plurality of microstructures 500. The microstructures 500 of FIGS. 4A, 4B, 4C, and 4D may be microstructures having a tetragonal cross-sectional shape in a flow direction of coolant as illustrated in FIGS. 1, 2, and 3. Referring to FIG. 4A, a plurality of microstructures 500Y may extend in the second direction (Y direction). The plurality of microstructures 500Y may be arranged in a 2D manner in the first direction (X direction) and the second direction (Y direction). According to this, the first capillary channel 510X and the first capillary channel 510Y respectively extending in the first direction (X direction) and the second direction (Y direction) may be formed between the plurality of microstructures 500Y, and a second capillary channel 520Y extending in the second direction (Y direction) may be formed in the plurality of microstructures 500Y. Referring to FIG. 4B, a plurality of microstructures 500X may extend in the first direction (X direction). The plurality of microstructures 500X may be arranged in a 2D manner in the first direction (X direction) and the second direction (Y direction). According to this, first capillary channels 510X and 510Y respectively extending in the first direction (X direction) and the second direction (Y direction) may be formed between the plurality of microstructures 500X, and a second capillary channel 520X extending in the first direction (X direction) may be formed in the plurality of microstructures 500X. FIGS. 4C and 4D each illustrate a combination of the plurality of microstructures 500Y of FIG. 4A and the plurality of microstructures 500X of FIG. 4B. Referring to FIG. 4C, the plurality of microstructures 500X may be arranged in the first direction (X direction) and the second direction (Y direction). The plurality of microstructures 500Y may be arranged in the first direction (X direction). Such arrangement may be repeated in the second direction (Y direction). Referring to FIG. 3D, the plurality of microstructures 500X and the plurality of microstructures 500Y may be arranged alternately in the first direction (X direction) and the second direction (Y direction).

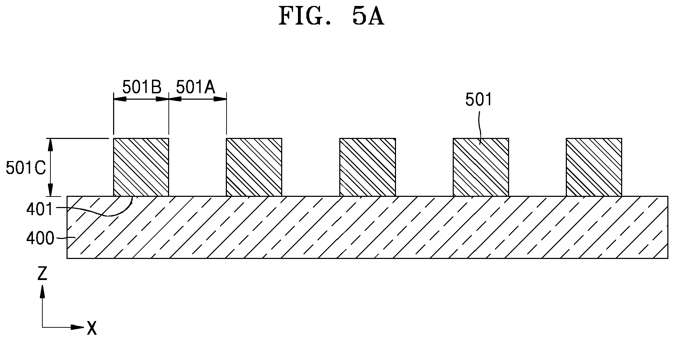

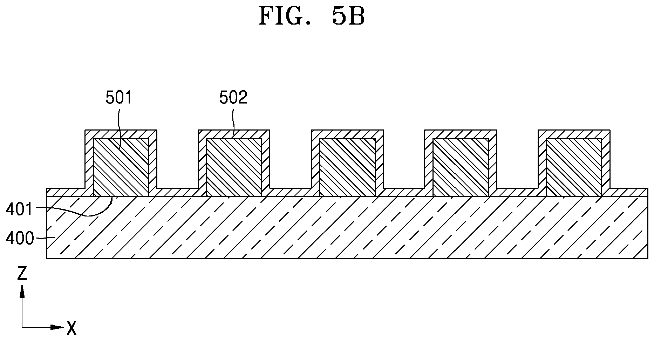

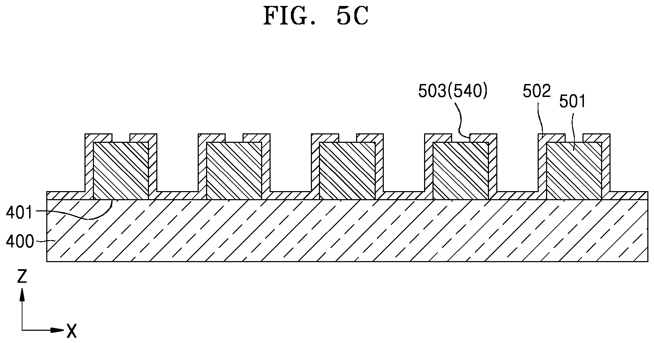

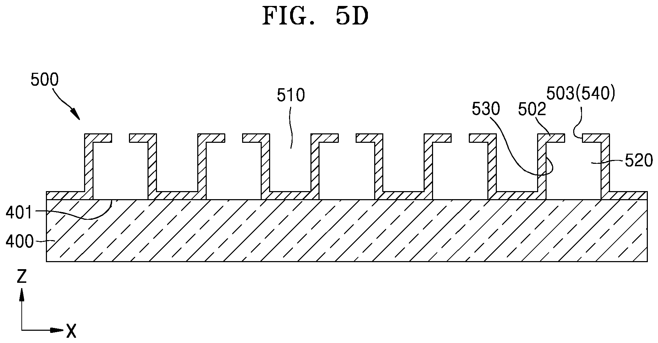

FIGS. 5A, 5B, 5C, and 5D are diagrams each illustrating an example of a method of manufacturing the microstructure 500 according to one or more embodiments illustrated in FIGS. 1, 2, and 3. Referring to FIG. 5A, a sacrificial layer may be formed on the upper surface 401 of the heat transfer member 400, and by etching the sacrificial layer, sacrificial layer patterns 501 copying a shape of the first capillary channel 510 and the second capillary channel 520 may be formed. The sacrificial layer patterns 501 may have, for example, a tetragonal cross-section. The sacrificial layer patterns 501 may be formed according to the arrangement formats of the microstructures 500 illustrated in FIGS. 4A, 4B, 4C, and 4D. The sacrificial layer patterns 501 may be formed of, for example, photoresist. An interval 501A between the sacrificial layer patterns 501, a width 501B, and a height 501C of each of the sacrificial layer patterns 501 may respectively correspond to the outer interval CD1, the inner interval CD2, and the height CD3 of the microstructure 500. The first capillary channel 510 may be defined by the height 501C of each of the sacrificial layer patterns 501 and the interval 501A between the sacrificial layer patterns 501. The second capillary channel 520 may be defined by the width 501B and the height 501C of each of the sacrificial layer patterns 501. The sacrificial layer patterns 501 may be formed of, for example, photoresist.

As illustrated in FIG. 5B, a structure layer 502 covering the upper surface 401 of the heat transfer member 400 and surfaces of the sacrificial layer patterns 501 may be formed. The structure layer 502 may include a material having high thermal conductivity, for example, a metal such as copper (Cu). The structure layer 502 may be formed by depositing a metal on the upper surface 401 of the heat transfer member 400 and the surfaces of the sacrificial layer patterns 501.

As illustrated in FIG. 5C, an opening 503 exposing the sacrificial layer patterns 501 may be formed in an upper surface of the structure layer 502. The opening 503 may extend, for example, in the second direction (Y direction). The opening 503 may be formed by an etching process. For example, an etching mask including an etching hole defining the opening 503 may be formed on the upper surface of the structure layer 502, and by etching the structure layer 502 through the etching hole, the opening 503 may be formed. The opening 503 may form the second opening 540 described above.

The sacrificial layer patterns 501 in the structure layer 502 may be removed through the opening 503. This process may be performed by, for example, melting the sacrificial layer patterns 501 by using a solvent. The first opening 530 may be formed by etching at least one end of both ends of the structure layer 502 in an extension direction of the structure layer 502. The process of forming the first opening 530 may be integrated into the process of forming the opening 503 described above. According to the above, as illustrated in FIG. 5D, the microstructure 500 including the first capillary channel 510 and the second capillary channel 520 and the first opening 530 and the second opening 540 may be formed.

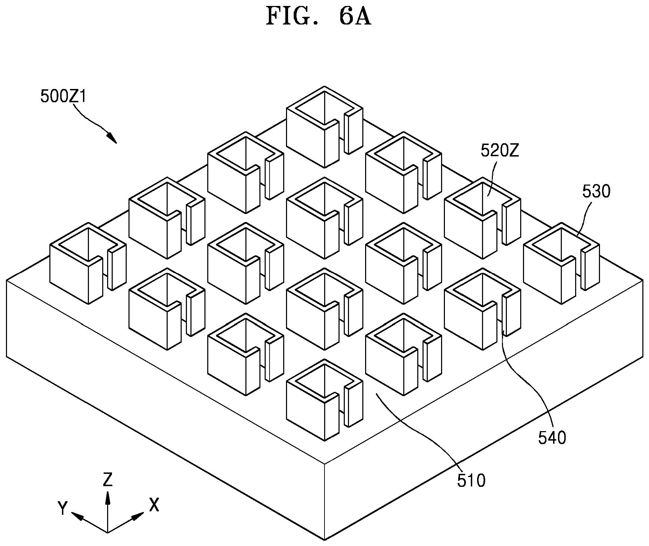

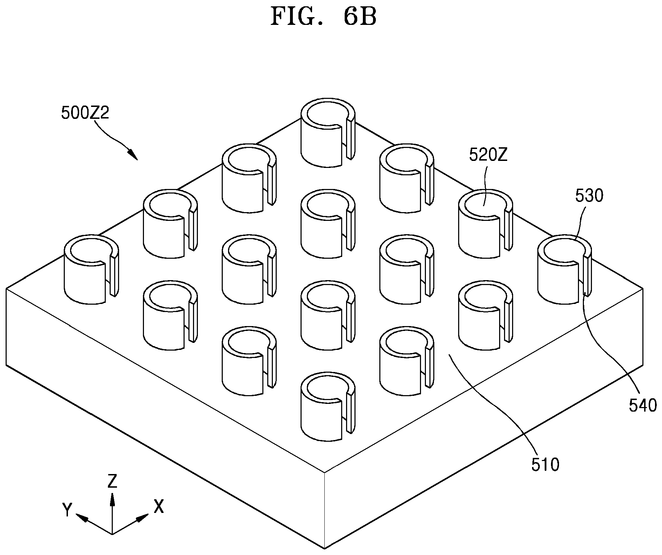

In the aforementioned embodiments, the microstructure 500 may extend in the first direction (X direction) or the second direction (Y direction). That is, the second capillary channel 520 may extend in the first direction (X direction) or the second direction (Y direction). The microstructure may extend in the third direction (Z direction), and in this case, the second capillary channel may extend in the third direction (Z direction). FIGS. 6A and 6B are schematic perspective views of examples of a microstructure. Referring to FIG. 6A, a microstructure 500Z1 may extend in the third direction (Z direction) and a cross-sectional shape of the microstructure 500Z1 perpendicular to the third direction (Z direction) may be tetragonal. The microstructure 500Z1 may be a hollow microstructure having a rectangular shape which is empty inside. According to the above, a second capillary channel 520Z extending in the third direction (Z direction) may be formed in the microstructure 500Z1. The first capillary channel 510 may be formed between the plurality of microstructure 500Z1 outside of the plurality of microstructure 500Z1. The first opening 530 may be formed on an upper surface of the microstructure 500Z1. At least one second opening 540 may be formed on a lateral surface of the microstructure 500Z1 perpendicular to the third direction (Z direction). Referring to FIG. 6B, a microstructure 500Z2 may extend in the third direction (Z direction) and a cross-sectional shape of the microstructure 500Z2 perpendicular to the third direction (Z direction) may be circular. The microstructure 500Z2 may be a hollow microstructure having a cylindrical shape which is empty inside. According to the above, the second capillary channel 520Z extending in the third direction (Z direction) may be formed in the microstructure 500Z2. The first capillary channel 510 may be formed outside of the plurality of microstructure 500Z2. The first opening 530 may be formed on an upper surface of the microstructure 500Z2. At least one second opening 540 may be formed on a lateral surface of the microstructure 500Z2 perpendicular to the third direction (Z direction).

The extension direction, the shape of cross-section perpendicular to the extension direction, and the arrangement of the plurality of microstructures are not limited to the examples illustrated in FIGS. 1, 2, 3, 4A, 4B, 4C, 4D, 6A, and 6B.

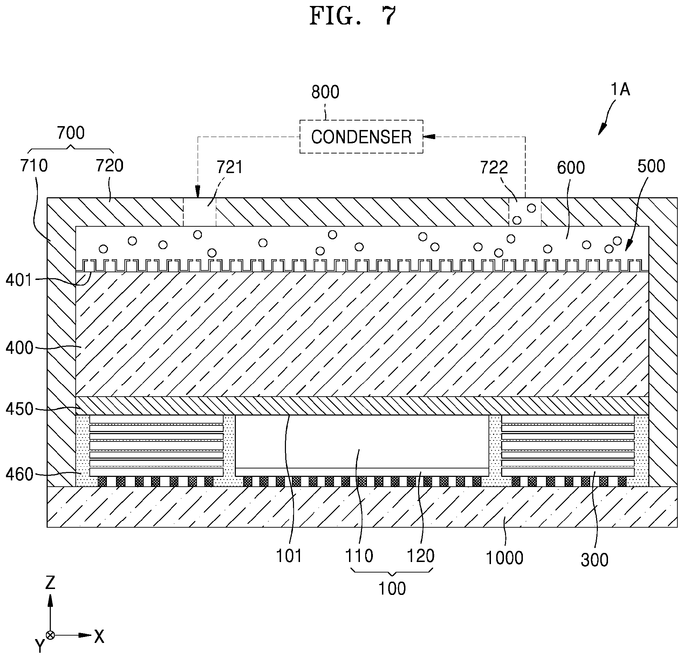

Although the embodiments of the semiconductor device 1 having a cooling structure which uses the immersion cooling method are described above, the semiconductor device 1 may a cooling structure using different cooling methods. FIG. 7 is a schematic block diagram of an example of a semiconductor device 1A. The semiconductor device 1A according to the embodiment may be different from the semiconductor device 1 illustrated in FIGS. 1, 2, and 3 in that the semiconductor device 1A includes a housing 700. Like reference numerals denote like members, and any redundant description will be omitted.

The housing 700 is illustrated in FIG. 7. The housing 700 may surround the semiconductor chip 100. The housing 700 may surround the semiconductor chip 100, the semiconductor chip 300, the heat transfer member 400, and the plurality of microstructures 500. For example, the housing 700 may include a side wall 710 and an upper wall 720. The side wall 710 may be supported by the printed circuit board 1000 and extend in the third direction (Z direction). The upper wall 720 may be arranged on the plurality of microstructures 500. Accordingly, a cooling channel 600 may be formed under the upper wall 720. The cooling channel 600 may accommodate a coolant. The upper wall 720 of the housing 700 may function as a cooling plate which exchanges heat with the outside air. A cooling fin may be installed on an outer surface of the upper wall 720.

The heat generated at the semiconductor integrated circuit 120 of the semiconductor chip 100 may be transferred to the heat transfer member 400 via the substrate 110 and the TIM 450. The liquid coolant in the cooling channel 600 may be quickly supplied to the upper surface 401 of the heat transfer member 400 along the first capillary channel 510 and the second capillary channel 520 formed by the plurality of microstructures 500. The liquid coolant may be heated through the heat exchange with the heat transfer member 400 and may be phase-changed into a vapor coolant. The vapor coolant may come out of the first capillary channel 510 and the second capillary channel 520. The vapor coolant may be condensed through the exchange with the upper wall 720 of the housing 700 and then resupplied to the cooling channel 600. In the area of the first capillary channel 510 and the second capillary channel 520, from which the vapor coolant has left, the liquid coolant may be supplied and filled by the capillary force generated by the plurality of microstructures 500.

As marked with the dotted line in FIG. 7, one or more opening 721 and opening 722 interconnected with the cooling channel 600 may be provided in the upper wall 720 of the housing 700. One of the opening 721 and the opening 722, for example, the opening 721 may be a supply opening through which the liquid coolant is supplied to the cooling channel 600, and the other one may be a discharge opening through which the vapor coolant is discharged from the cooling channel 600. The vapor coolant discharged from the cooling channel 600 through the opening 722 (as the discharge opening) may be condensed into a liquid coolant at a condenser 800 and then supplied to the cooling channel 600 through the opening 721 (as the supply opening).

According to such structure, the following effects may be further obtained in addition to the effects achieved by the hollow microstructure described above. An amount of coolant accommodated in the cooling channel 600 formed inside the housing 700 packaging the semiconductor chip 100 may be to such an extent that the plurality of microstructures 500 are immersed in the coolant. Accordingly, in comparison with the immersion cooling method, the cooling system may be implemented with a smaller amount of coolant, and the coolant may not need to be a dielectric coolant. Moreover, as the coolant is supplied to the heat exchange surface by the capillary force, the energy consumed for driving of the cooling structure may decrease, which leads to relatively reduced maintenance.

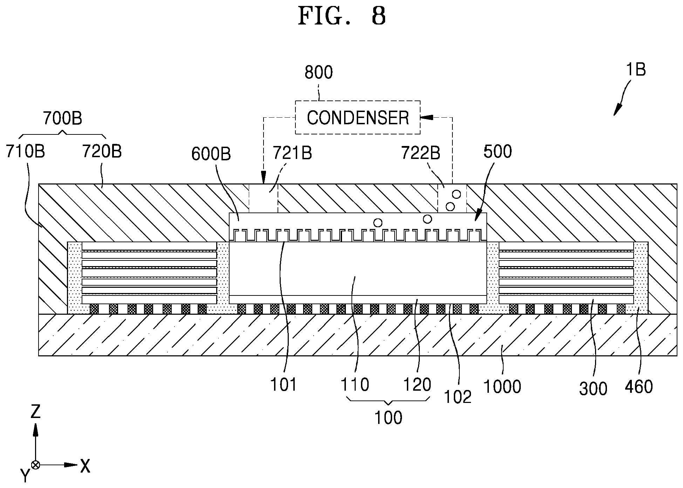

The microstructures 500 may be formed on the semiconductor chip 100. FIG. 8 is a schematic block diagram of an example of a semiconductor device 1B. The semiconductor device 1B according to the embodiment may be different from the semiconductor device 1A illustrated in FIG. 7 in that the microstructures 500 are formed on the semiconductor chip 100. Like reference numerals denote like members, and any redundant description will be omitted. Referring to FIG. 8, the semiconductor device 1B may include a cooling channel 600B thermally connected to the semiconductor chip 100. The plurality of microstructures 500 on which a coolant for cooling the semiconductor chip flows may be provided in the cooling channel 600B. The plurality of microstructures 500 may generate a capillary force causing a flow of the coolant in the cooling channel 600B. As described above, the first capillary channel 510 may be formed between the plurality of microstructures 500, and at least some of the plurality of microstructures 500 may be a hollow microstructure in which the second capillary channel 520 is formed.

The semiconductor chip 100 may include a lower surface 102 on which the semiconductor integrated circuit 120 is formed and the upper surface 101 opposite to the lower surface 102. The cooling channel 600B may be formed adjacent to the upper surface 101. The cooling channel 600B may be formed between a housing 700B and the upper surface 101 of the semiconductor chip 100. For example, the housing 700B may surround the semiconductor chip 100. The housing 700B may surround the semiconductor chip 100, the semiconductor chip 300, and the plurality of microstructures 500. For example, the housing 700B may include a side wall 710B and an upper wall 720B. The side wall 710B may be supported by the printed circuit board 1000 and extend in the third direction (Z direction). The upper wall 720B may be arranged apart from the upper surface 101 of the semiconductor chip 100. Accordingly, the cooling channel 600B may be formed between the upper wall 720B and the upper surface 101 of the semiconductor chip 100. The cooling channel 600B may accommodate a coolant. The upper wall 720B of the housing 700B may function as a cooling plate which exchanges heat with the outside air. A cooling fin may be installed on an outer surface of the upper wall 720B.

The microstructures 500 may be formed on the upper surface 101 of the semiconductor chip 100. The upper surface 101 of the semiconductor chip 100 may form a lower surface of the cooling channel 600B. The upper surface 101 of the semiconductor chip 100 may be a heat exchange surface on which heat exchange with a coolant is performed. The semiconductor chip 100 may be a semiconductor integrated circuit chip of wafer level. The substrate 110 may be a wafer. The microstructures 500 may be formed on the upper surface 101 of the semiconductor chip 100 by the manufacturing process described in relation to FIGS. 4A, 4B, 4C, and 4D. In this case, the heat transfer member 400 in FIGS. 4A, 4B, 4C, and 4D may be replaced with the substrate 110.

The heat generated at the semiconductor integrated circuit 120 of the semiconductor chip 100 may be transferred to the upper surface 101 of the semiconductor chip 100 which is a heat exchange surface. The liquid coolant in the cooling channel 600B may be quickly supplied to the upper surface 101 of the semiconductor chip 100 along the first capillary channel 510 and the second capillary channel 520 formed by the plurality of microstructures 500. The liquid coolant may be heated through the heat exchange with the upper surface 101 of the semiconductor chip 100 and may be phase-changed into a vapor coolant. The vapor coolant may come out of the first capillary channel 510 and the second capillary channel 520. The vapor coolant may be condensed through the exchange with the upper wall 720B of the housing 700B and then resupplied to the cooling channel 600B. In the area of the first capillary channel 510 and the second capillary channel 520, from which the vapor coolant has left, the liquid coolant may be supplied and filled by the capillary force generated by the plurality of microstructures 500.

As marked with the dotted line in FIG. 8, one or more of opening 721B and opening 722B interconnected with the cooling channel 600B may be provided in the upper wall 720B of the housing 700B. One of the opening 721B and the opening 722B, for example, the opening 721B may be a supply opening through which the liquid coolant is supplied to the cooling channel 600B, and the other one may be a discharge opening through which the vapor coolant is discharged from the cooling channel 600B. The vapor coolant discharged from the cooling channel 600B through the opening 722B (as the discharge opening) may be condensed into a liquid coolant at the condenser 800 and then supplied to the cooling channel 600B through the opening 721B (as the supply opening).

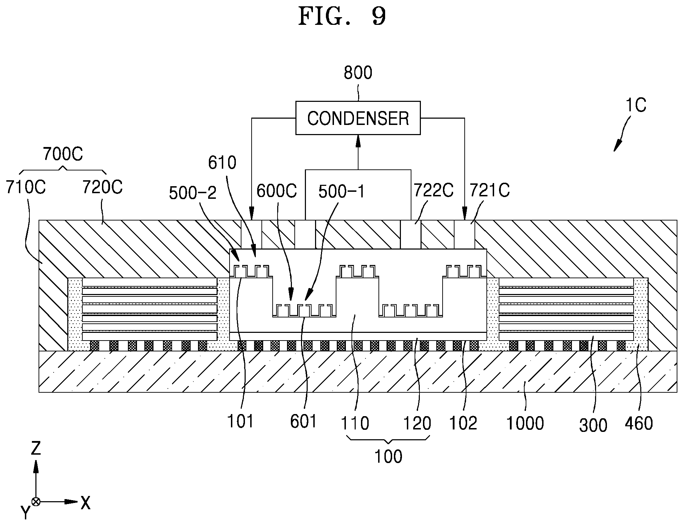

FIG. 9 is a schematic block diagram of an example of a semiconductor device 1C. The semiconductor device 1C according to the embodiment may be different from the semiconductor device 1B illustrated in FIG. 8 in that a cooling channel 600C is formed in the semiconductor chip 100. Like reference numerals denote like members, and any redundant description will be omitted. Referring to FIG. 9, the semiconductor device 1C may include the cooling channel 600C thermally connected to the semiconductor chip 100. The semiconductor chip 100 may include the lower surface 102 on which the semiconductor integrated circuit 120 is formed and the upper surface 101 opposite to the lower surface 102. The cooling channel 600C may be formed to be recessed from the upper surface 101 of the semiconductor chip 100 towards the semiconductor integrated circuit 120.

A plurality of microstructures 500-1 on which a coolant for cooling the semiconductor chip flows may be provided in the cooling channel 600C. The plurality of microstructures 500-1 may generate a capillary force causing a flow of the coolant in the cooling channel 600C. As described above, the first capillary channel 510 may be formed between the plurality of microstructures 500-1, and at least some of the plurality of microstructures 500-1 may be a hollow microstructure in which the second capillary channel 520 is formed. The microstructures 500-1 may be formed on a bottom surface 601 of the cooling channel 600C. The bottom surface 601 of the cooling channel 600C may be a heat exchange surface on which heat exchange with a coolant is performed. Descriptions on the microstructures 500 may be applied to the microstructures 500-1 as well. The semiconductor chip 100 may be a semiconductor integrated circuit chip of wafer level. The substrate 110 may be a wafer. The microstructures 500-1 may be formed on the upper surface 101 of the semiconductor chip 100 by the manufacturing process described in relation to FIGS. 4A, 4B, 4C, and 4D. In this case, the upper surface 401 of the heat transfer member 400 in FIG. 4A, 4B, 4C, and 4D may be replaced with the bottom surface 601 of the cooling channel 600C.

A housing 700C may surround the semiconductor chip 100. The housing 700C may surround the semiconductor chip 100, the semiconductor chip 300, and the plurality of microstructures 500-1. For example, the housing 700C may include a side wall 710C and an upper wall 720C. The side wall 710C may be supported by the printed circuit board 1000 and extend in the third direction (Z direction). The upper wall 720C may be arranged apart from the upper surface 101 of the semiconductor chip 100. One or more of opening 721C and opening 722C interconnected with the cooling channel 600C may be provided in the upper wall 720C of the housing 700C. One of the opening 721C and the opening 722C, for example, the opening 721C may be a supply opening through which the liquid coolant is supplied to the cooling channel 600C, and the other one, i.e., the opening 722C may be a discharge opening through which the vapor coolant is discharged from the cooling channel 600C. The vapor coolant discharged from the cooling channel 600C through the opening 722C (as the discharge opening) may be condensed into a liquid coolant at a condenser 800 and then supplied to the cooling channel 600C through the opening 721C (as the supply opening).

A supply channel 610 may be provided between the upper surface 101 of the semiconductor chip 100 and the upper wall 720C of the housing 700C. The supply channel 610 may connect the supply opening 721C to the cooling channel 600C. A plurality of microstructures 500-2 may be provided in the supply channel 610. Descriptions on the microstructures 500 may be applied to the microstructures 500-2 as well. The liquid coolant supplied to the supply channel 610 through the supply opening 721C may be supplied to the cooling channel 600C by the capillary force generated by the microstructures 500-2.

The heat generated at the semiconductor integrated circuit 120 of the semiconductor chip 100 may be transferred to the bottom surface 601 of the cooling channel 600C which is a heat exchange surface. The liquid coolant in the cooling channel 600C may be quickly and evenly supplied to the entire bottom surface 601 of the cooling channel 600C along the first capillary channel 510 and the second capillary channel 520 formed by the plurality of microstructures 500-1. The liquid coolant may be heated through the heat exchange with the bottom surface 601 of the cooling channel 600C and may be phase-changed into a vapor coolant. The vapor coolant may come out of the first capillary channel 510 and the second capillary channel 520. The vapor coolant discharged from the cooling channel 600C may move to the condenser 800 through the discharge opening 722C. The vapor coolant may be condensed into a liquid coolant in the condenser 800, and the liquid coolant may be supplied to the cooling channel 600B via the supply channel 610 through the supply opening 721B. In the area of the first capillary channel 510 and the second capillary channel 520, from which the vapor coolant has left, the liquid coolant may be supplied and filled by the capillary force generated by the plurality of microstructures 500-1.

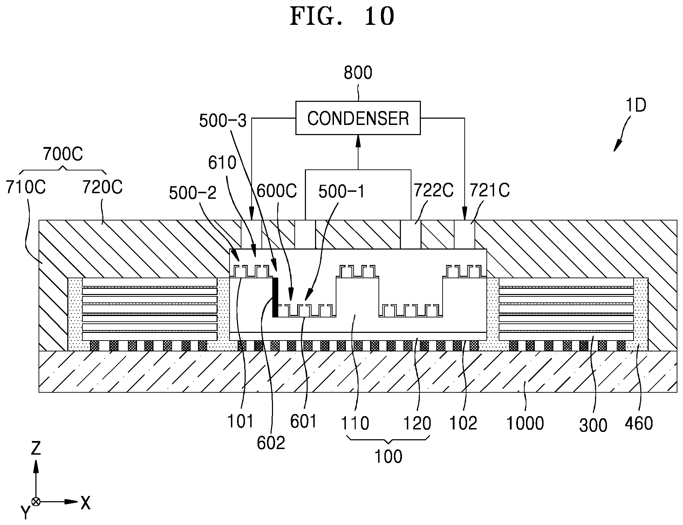

FIG. 10 is a schematic block diagram of an example of a semiconductor device 1D. Referring to FIG. 10, the semiconductor device 1D according to the embodiment may be different from the semiconductor device 1C illustrated in FIG. 9 in that a plurality of microstructures 500-3 are provided on a side wall 602 of the cooling channel 600C. Like reference numerals denote like members, and any redundant description will be omitted. The side wall 602 may be extend from the bottom surface 601 of the cooling channel 600C to the upper surface 101 of the semiconductor chip 100 in the thickness direction, i.e., the Z direction and may be connected to the supply channel 610. The microstructures 500-3 may generate a capillary force moving the liquid coolant supplied from the supply channel 610 to the bottom surface 601 of the cooling channel 600C along the side wall 602. A cross-sectional shape of the microstructure 500-3 according to the XY plane may be polygonal, circular, elliptical, etc. The microstructure 500-3 may be a hollow microstructure like the microstructure 500. In this case, descriptions on the microstructures 500 may be applied to the microstructures 500-3 as well. According to the aforementioned structure, a liquid coolant LC may be quickly and stably supplied from the supply channel 610 to the bottom surface 601 along a wall surface 602.

According to the foregoing embodiments of the semiconductor device of the disclosure, by employing a plurality of microstructures including a hollow microstructure, a large amount of liquid coolant may be supplied to a heat exchange surface. According to the foregoing embodiments of the semiconductor device of the disclosure, by employing a hollow microstructure, an area of a surface exchanging heat with a coolant may increase.

**Claims**

1. A semiconductor device comprising:a semiconductor chip (100) comprising a semiconductor integrated circuit;a heat transfer member (400) covering an upper surface of the semiconductor chip (100); and a plurality of microstructures (500) on an upper surface (401) of the heat transfer member (400) and configured to generate a capillary force to cause a flow of a coolant,wherein a first capillary channel (510) is provided between adjacent microstructures of the plurality of microstructures (500) , **characterised in that** :
   at least one of the plurality of microstructures comprises a hollow microstructure in which a second capillary channel (520) is provided.

2. The semiconductor device of claim 1, wherein a difference between a first capillary interval of the first capillary channel and a second capillary interval of the second capillary channel is less than or equal to half of any of the first capillary interval and the second capillary interval.

3. The semiconductor device of claim 1, wherein a first capillary interval of the first capillary channel is the same as a second capillary interval of the second capillary channel.

4. The semiconductor device of any preceding claim, wherein the first capillary channel is interconnected with the second capillary channel.

5. The semiconductor device of any preceding claim, wherein a first opening interconnecting the first capillary channel with the second capillary channel is provided at at least one of ends of the hollow microstructure in an extension direction of the second capillary channel.

6. The semiconductor device of any preceding claim, wherein a second opening, open in a direction perpendicular to an extension direction of the second capillary channel, is provided at the hollow microstructure.

7. The semiconductor device of claim 6, wherein an opening interval of the second opening is less than or equal to half of a second capillary interval of the second capillary channel.

8. The semiconductor device of any preceding claim, wherein the heat transfer member comprises:

   a cooling channel thermally connected to the semiconductor chip and configured to accommodate a coolant which flows therein, and wherein the plurality of microstructures is positioned in the cooling channel.

9. The semiconductor device of claim 8, further comprising a housing surrounding the semiconductor chip,
   wherein the cooling channel is between the housing and the upper surface of the semiconductor chip.

10. The semiconductor device of claim 9, wherein at least one opening interconnected with the cooling channel is provided in the housing.

11. The semiconductor device of any of claims 8 to 10, wherein the semiconductor chip comprises a lower surface and an upper surface opposite to the lower surface,

    wherein the semiconductor integrated circuit is on the lower surface, and
    wherein the cooling channel is recessed from the upper surface.

12. The semiconductor device of claim 11, wherein the plurality of microstructures are on a bottom surface of the cooling channel that is closer to the lower surface of the semiconductor chip than to the upper surface of the semiconductor chip.

**Patentansprüche**

1. Halbleitervorrichtung, umfassend: einen Halbleiterchip (100), der eine integrierte Halbleiterschaltung umfasst; ein Wärmeübertragungselement (400), das eine obere Fläche des Halbleiterchips (100) bedeckt; und eine Vielzahl von Mikrostrukturen (500) auf einer oberen Fläche (401) des Wärmeübertragungselements (400) und konfiguriert, um eine Kapillarkraft zu erzeugen, um einen Fluss eines Kühlmittels zu bewirken, wobei ein erster Kapillarkanal (510) zwischen benachbarten Mikrostrukturen aus der Vielzahl von Mikrostrukturen (500) bereitgestellt ist, **dadurch gekennzeichnet, dass**: zumindest eine aus der Vielzahl von Mikrostrukturen eine hohle Mikrostruktur umfasst, in der ein zweiter Kapillarkanal (520) bereitgestellt ist.

2. Halbleitervorrichtung nach Anspruch 1, wobei eine Differenz zwischen einem ersten Kapillarintervall des ersten Kapillarkanals und einem zweiten Kapillarintervall des zweiten Kapillarkanals weniger als die oder gleich der Hälfte eines beliebigen von dem ersten Kapillarintervall und dem zweiten Kapillarintervall ist.

3. Halbleitervorrichtung nach Anspruch 1, wobei ein erstes Kapillarintervall des ersten Kapillarkanals das gleiche wie ein zweites Kapillarintervall des zweiten Kapillarkanals ist.

4. Halbleitervorrichtung nach einem vorhergehenden Anspruch, wobei der erste Kapillarkanal mit dem zweiten Kapillarkanal verbunden ist.

5. Halbleitervorrichtung nach einem vorhergehenden Anspruch, wobei eine erste Öffnung, die den ersten Kapillarkanal mit dem zweiten Kapillarkanal verbindet, an zumindest einem von Enden der hohlen Mikrostruktur in einer Erstreckungsrichtung des zweiten Kapillarkanals bereitgestellt ist.

6. Halbleitervorrichtung nach einem vorhergehenden Anspruch, wobei eine zweite Öffnung, die in einer Richtung senkrecht zu einer Erstreckungsrichtung des zweiten Kapillarkanals offen ist, an der hohlen Mikrostruktur bereitgestellt ist.

7. Halbleitervorrichtung nach Anspruch 6, wobei ein Öffnungsintervall der zweiten Öffnung weniger als die oder gleich der Hälfte eines zweiten Kapillarintervalls des zweiten Kapillarkanals ist.

8. Halbleitervorrichtung nach einem vorhergehenden Anspruch, wobei das Wärmeübertragungselement Folgendes umfasst:

    einen Kühlkanal, der thermisch mit dem Halbleiterchip verbunden und konfiguriert ist, um ein Kühlmittel aufzunehmen, das darin fließt, und wobei die Vielzahl von Mikrostrukturen in dem Kühlkanal positioniert ist.

9. Halbleitervorrichtung nach Anspruch 8, ferner umfassend ein Gehäuse, das den Halbleiterchip umgibt,
wobei der Kühlkanal zwischen dem Gehäuse und der oberen Fläche des Halbleiterchips ist.

10. Halbleitervorrichtung nach Anspruch 9, wobei zumindest eine Öffnung, die mit dem Kühlkanal verbunden ist, in dem Gehäuse bereitgestellt ist.

11. Halbleitervorrichtung nach einem der Ansprüche 8 bis 10, wobei der Halbleiterchip eine untere Fläche und eine obere Fläche gegenüber der unteren Fläche umfasst,

    wobei die integrierte Halbleiterschaltung auf der unteren Fläche ist und
    wobei der Kühlkanal von der oberen Fläche ausgespart ist.

12. Halbleitervorrichtung nach Anspruch 11, wobei die Vielzahl von Mikrostrukturen auf einer Bodenfläche des Kühlkanals ist, die näher an der unteren Fläche des Halbleiterchips als an der oberen Fläche des Halbleiterchips ist.

**Revendications**

1. Dispositif semi-conducteur comprenant : une puce à semi-conducteur (100) comprenant un circuit intégré semi-conducteur ; un élément de transfert de chaleur (400) recouvrant une surface supérieure de la puce à semi-conducteur (100) ; et une pluralité de microstructures (500) sur une surface supérieure (401) de l'élément de transfert de chaleur (400) et conçues pour générer une force capillaire pour provoquer un écoulement d'un liquide de refroidissement, dans lequel un premier canal capillaire (510) est prévu entre des microstructures adjacentes de la pluralité de microstructures (500), **caractérisé en ce que** : au moins l'une de la pluralité de microstructures comprend une microstructure creuse où un second canal capillaire (520) est prévu.

2. Dispositif semi-conducteur de la revendication 1, dans lequel une différence entre un premier intervalle capillaire du premier canal capillaire et un second intervalle capillaire du second canal capillaire est inférieure ou égale à la moitié de l'un quelconque du premier intervalle capillaire et du second intervalle capillaire.

3. Dispositif semi-conducteur de la revendication 1, dans lequel un premier intervalle capillaire du premier canal capillaire est identique à un second intervalle capillaire du second canal capillaire.

4. Dispositif semi-conducteur d'une quelconque revendication précédente, dans lequel le premier canal capillaire est relié au second canal capillaire.

5. Dispositif semi-conducteur d'une quelconque revendication précédente, dans lequel une première ouverture reliant le premier canal capillaire au second canal capillaire est prévue au niveau d'au moins une d'extrémités de la microstructure creuse dans une direction d'extension du second canal capillaire.

6. Dispositif semi-conducteur d'une quelconque revendication précédente, dans lequel une seconde ouverture, ouverte dans une direction perpendiculaire à une direction d'extension du second canal capillaire, est prévue au niveau de la microstructure creuse.

7. Dispositif semi-conducteur de la revendication 6, dans lequel un intervalle d'ouverture de la seconde ouverture est inférieur ou égal à la moitié d'un second intervalle capillaire du second canal capillaire.

8. Dispositif semi-conducteur d'une quelconque revendication précédente, dans lequel l'élément de transfert de chaleur comprend :

   un canal de refroidissement lié thermiquement à la puce à semi-conducteur et conçu pour recevoir un liquide de refroidissement qui s'y écoule, et
   dans lequel la pluralité de microstructures est positionnée dans le canal de refroidissement.

9. Dispositif semi-conducteur de la revendication 8, comprenant en outre un boîtier entourant la puce à semi-conducteur,
   dans lequel le canal de refroidissement se situe entre le boîtier et la surface supérieure de la puce à semi-conducteur.

10. Dispositif semi-conducteur de la revendication 9, dans lequel au moins une ouverture reliée au canal de refroidissement est prévue dans le boîtier.

11. Dispositif semi-conducteur de l'une quelconque des revendications 8 à 10, dans lequel la puce à semi-conducteur comprend une surface inférieure et une surface supérieure opposée à la surface inférieure, dans lequel le circuit intégré à semi-conducteur se situe sur la surface inférieure, et dans lequel le canal de refroidissement se situe en retrait par rapport à la surface supérieure.

12. Dispositif à semi-conducteur de la revendication 11, dans lequel la pluralité de microstructures se situent sur une surface inférieure du canal de refroidissement qui est plus proche de la surface inférieure de la puce à semi-conducteur que de la surface supérieure de la puce à semi-conducteur.

# FIG. 1

1

500

401

400

450

300

460

1000

101   110   120

100

Z

Y   X

## FIG. 2

# FIG. 3

FIG. 4A

# FIG. 4B

FIG. 4C

# FIG. 4D

# FIG. 5A

# FIG. 5B

FIG. 5C

FIG. 5D

FIG. 6A

EP 4 542 643 B1

# FIG. 6B

26

FIG. 7

FIG. 9

## FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019348345 A1